# EUROPEAN PATENT APPLICATION

(11) **EP 3 432 693 A1**
(43) Date of publication of application: **23.01.2019**
(21) Application number: 17183106.8
(22) Date of filing: 25.07.2017
(51) Int. Cl.: H05K 1/09, H05K 3/10, H05K 3/24, H05K 3/06, H05K 1/03

(54) **ENCAPSULATION OF CIRCUIT TRACE**

(30) Priority: 19.07.2017 US 201715653704
(71) Applicant: Anaren, Inc., East Syracuse, NY 13057 (US)
(72) Inventor: LEN, Michael J., Skaneateles, New York 13152 (US); JENSEN, Bo, Minoa, New York 13116 (US)
(74) Representative: Strehl Schübel-Hopf & Partner

(57) **Abstract**

An approach for protecting the circuit trade of a printed circuit board from oxidation that may occur due the permeability of the underlying substrate (12). A layer of silver is positioned between the circuit trace (14) and the substrate (12), such as by immersion plating, during manufacturing of the printed circuit board. The layer of silver is preferably applied over the seed-conductor after a negative photo resist layer has been applied to the substrate (12) and before the copper is plated to form the circuit trace (14). The resist and seed-conductor (22) outside of the circuit trace (14) may then be removed to leave the protected circuit trace (14). An additional layer of silver may be plated over the copper trace to protect the exterior and side surface of the trace.

## Description

### BACKGROUND OF THE INVENTION

### 1. FIELD OF THE INVENTION

The present invention relates to printed circuit board manufacturing and, more specifically, to an approach for preventing oxidation of copper circuit traces thereon.

### 2. DESCRIPTION OF THE RELATED ART

Printed circuit boards contain a dielectric substrate having one or more conductive circuit traces. Typically, the circuit traces are made from copper due to its low resistivity. At high temperatures, however, the dielectric substrates used for printed circuit boards have increased permeability such that the underside of the copper traces will oxidize and, as a result, have degraded performance. For example, polytetrafluoroethylene (PTFE) based dielectric materials have a high material operating temperature (327 °C) but have increased permeability at lower operating temperatures such as 125 °C. Consequently, a circuit trace positioned on a PTFE substrate will have an effective maximum operating temperature (MOT) that is much lower than the 327 °C due to the oxidation of the underside of the circuit traces that occurs as a result of the increased permeability of the dielectric. While polyimide based dielectric materials have very low permeability and high operating temperatures, they have low thermal conductivity of 0.25 W/mK to 0.5W/mK and thus do not solve the problem.

The conventional approach to preventing oxidation in general is to plate a protective layer over the copper trace, such as hot air solder leveling (HASL), electroless nickel immersion gold (ENIG), electroless nickel electroless palladium immersion gold (ENEPIG), immersion tin, immersion silver, and organic solderability preservative (OSP). This approach, however, does not prevent oxidation underneath the trace where it is positioned against the dielectric substrate and is subject to oxidation through the substrate when operating temperatures increase. As a result, the conventional approach to oxidation still requires limiting the maximum operating temperature so that oxygen will not readily permeate through the PCB material to the unprotected side of the copper trace at the dielectric-to-copper trace interface.

Consequently, there are no existing PCB dielectric materials with high operating temperatures, high thermal conductivity, and low permeability as the circuit trace is subject to oxidation during high temperature operation when used in conjunction with materials that have high permeability at those higher temperatures. Accordingly, there is a need in the art for an approach that can protect an entire trace from oxidation at higher temperatures without interfering with the performance of the printed circuit board.

### BRIEF SUMMARY OF THE INVENTION

The present invention comprises an approach for protecting the circuit traces of a printed circuit board protected against oxidation through the substrate of the printed circuit board. A printed circuit board according to the present invention comprises a substrate formed from a dielectric material, a layer of a conductive material positioned on the substrate and forming a circuit trace, and a layer of a noble metal interposed between the circuit trace and the conductive material. The noble metal may comprise silver and the conductive material may comprise copper. A seed conductor may be interposed between the layer of the noble metal and the conductive material. The layer of the noble metal is preferably about 0.305 µm (12 microinches) in thickness. The dielectric material may be polytetrafluoroethylene and the printed circuit board of will have a maximum operating temperature of at least 200 degrees Celsius.

The present invention also includes a first embodiment of a method of forming a printed circuit board having a circuit trace protected against substrate mediated oxidation. The method involves the steps of providing a dielectric substrate, positioning a seed conductor on the substrate, applying a layer of resist patterned with a negative image of a desired circuit trace, forming a first layer of a noble metal in the negative image of the desired circuit trace over the substrate and the layer of resist, plating a layer of a conductive material over the layer of noble metal to form the desired circuit trace, removing the layer of resist from the substrate, removing the layer of seed conductor from the substrate other than from the substrate in the desired circuit trace, and then plating a second layer of the noble metal over the layer of conductive material.

The present invention also includes a second embodiment of a method of forming a printed circuit board having a circuit trace protected against substrate mediated oxidation. This method involves the steps of providing a dielectric substrate, positioning a seed conductor on the substrate, forming a first layer of noble metal on the substrate, plating a layer of a conductive material over the layer of noble metal, applying a layer of resist patterned with an image of a desired circuit trace, removing the layer of resist and the seed conductor from the substrate to leave the desired circuit trace, and plating a second layer of silver over the layer of copper.

### BRIEF DESCRIPTION OF THE SEVERAL VIEWS OF THE DRAWING(S)

The present invention will be more fully understood and appreciated by reading the following Detailed Description in conjunction with the accompanying drawings, in which:
FIG. 1 is a schematic of a circuit trace of a printed circuit board that has been protected against oxidation according to the present invention;

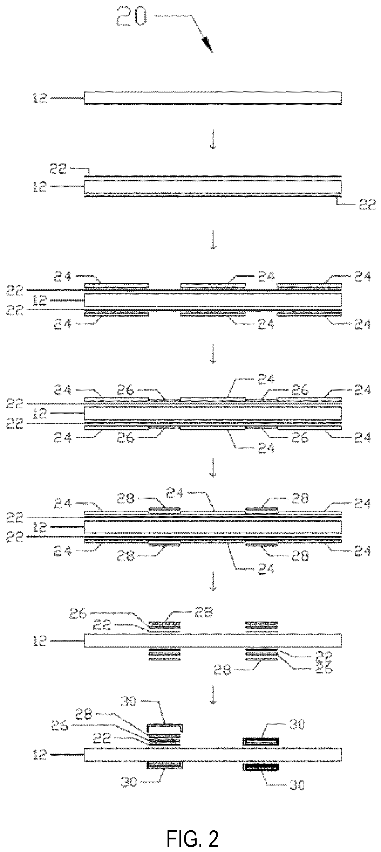

FIG. 2 is a schematic of a process for protecting a circuit trace of printed circuit board against oxidation according to the present invention; and

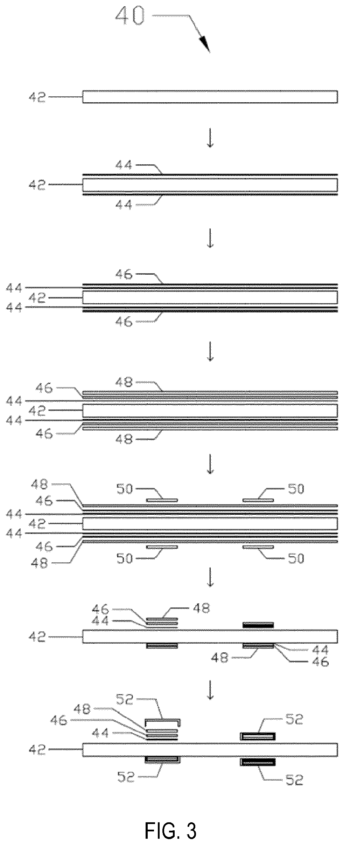

FIG. 3 is a schematic of an alternative process for protecting a circuit trace of printed circuit board against oxidation according to the present invention; and
FIG. 4 is a schematic of various printed circuit board stackups and the associated maximum operating temperature of the arrangements when protected according to the present invention.

### DETAILED DESCRIPTION OF THE INVENTION

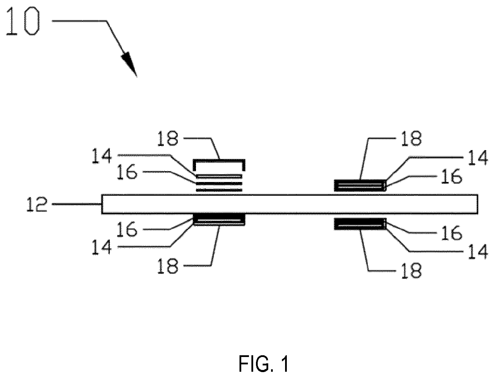

Referring to the figures, wherein like numerals refer to like parts throughout, there is seen in FIG. 1 a printed circuit board (PCB) 10 comprised of a dielectric substrate 12 supporting a circuit trace 14 that is protected from oxidation on all surfaces, including the substrate-to-trace interface. More specifically, a layer of silver 16 has been disposed between circuit trace 14 and substrate 12 to prevent oxidation of circuit trace 14 when temperature increases cause the permeability of substrate 12 to increase such that oxidation can occur. A second layer of silver 18 may additionally layered over and along the sides of circuit trace 14 as is known in the field to prevent oxidation of the upper and side surfaces of circuit trace 14.

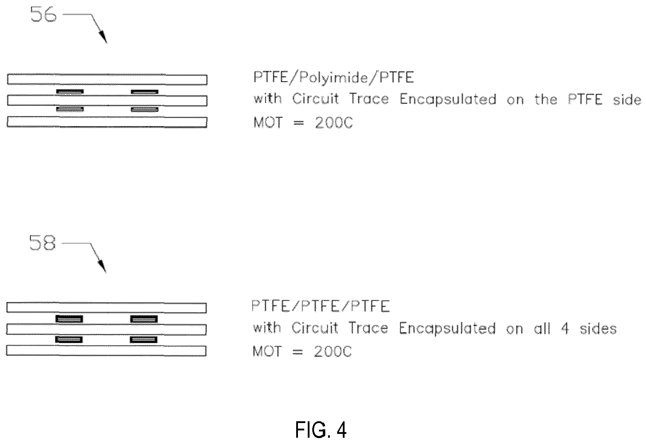

The present invention includes a PCB formation process 20 that begins with a dielectric substrate 12 for the desired printed circuit board. Next, a seed-conductor 22 is coated onto substrate 12. A layer of photo resist 24 is then applied over seed-conductor 22 to define a negative image of a desired circuit trace. Substrate 12 with seed-conductor 22 and photo resist 24 thereon is then immersed in silver plate to form a layer of silver 26 over the portion of seed-conductor 22 that are not covered by resist 24, *i.e.,* layer of silver 26 is applied to the regions where the circuit trace is to be formed. Notably, any noble metal may be used to protect the subsequently formed circuit trace from oxidation, such as gold, nickel, tin, or palladium, each of which has different characteristics, such as cost, formation of intermetallics, process availability, etc., and thus selected accordingly. The preferred thickness layer of silver 26 formed by immersion plating is 0.305 µm (12 microinches) and can be formed consistently with the thickness ranges as specified in IPC-4553 entitled "Specification for Immersion Silver Plating for Printed Boards." Substrate 12 having seed-conductor 22, resist 24 and silver 26 is then copper plated so that a layer of copper 28 is positioned over layer of silver 26 in the regions defined by resist 24 the circuit trace is desired. Etching is then used to remove resist 24 and seed-conductor 22 from around layers of silver 26 and copper 28. The remaining stackup is then immersed in silver plate to form a second layer of silver 30 that covers the sides and top of the copper layer 28. The final PCB 10 can be used as a two metal layer PCB or integrated to a multilayer PCB assembly as seen in FIG 4.

An alternative process 40 may involve a dielectric substrate 42 may be coated with a seed-conductor 44 and then immersed in silver plate to form a layer of silver 46. An electrolytic copper plate 48 may then be positioned over layer of silver 46. A positive resist 50 defining the desired circuit trace may then applied over layer of silver 46 and copper plate 46. Etching may then be used to remove copper 48, silver 46 and seed-conductor 44. Then strip the resist 50 thereby leaving only the areas where the circuit trace is desired. Finally, etched substrate 40 may be immersed in silver plate to provide another layer of silver 52 to protect the sides and top of the remaining copper plate 48 forming the circuit trace. As this alternative approach requires etching of the layer of silver 46 apart from the regions where the circuit trace is to be formed, it may not be favored over process 20 in any locations where environmental protection rules make the silver etching process cost prohibitive.

The use of immersion silver plating according to the present invention to provide a protective layer of silver under the layer of copper forming the circuit trace may be used in connection with PTFE/Polyimide/PTFE stackups, such as those illustrated in FIG. 4, to reduce the oxidation rate and increase the operating temperature. For example, the operating temperature may be increased up to at least 200 °C for PTFE/polyimide/PTFE stackups 56 by using silver plating on the PTFE sides and for PTFE/PTFE/PTFE stackups 58 by using silver plating under the circuit trace on all sides as oxidation of the copper trace is otherwise reduced.

## Claims

1. A printed circuit board protected against oxidation, comprising:
a substrate (12) formed from a dielectric material;
a layer of a conductive material (28) positioned on the substrate (12) and forming a circuit trace (14); and
a layer of a noble metal (16) interposed between the circuit trace (14) and the dielectric material.

2. The printed circuit board of claim 1, wherein the noble metal (16) comprises silver.

3. The printed circuit board of claim 2, wherein the conductive material (28) is copper.

4. The printed circuit board of claim 3, further comprising a seed conductor (22) interposed between the layer of the noble metal (16) and the conductive material (28).

5. The printed circuit board of claim 4, wherein the layer of the noble metal (16) is 0.305 µm (12 microinches) in thickness.

6. The printed circuit board of claim 5, wherein the dielectric material is polytetrafluoroethylene.

7. The printed circuit board of claim 6, wherein the printed circuit board has a maximum operating temperature of at least 200 degrees Celsius.

8. A method of forming a printed circuit board, comprising the steps of:
providing a dielectric substrate (12);
positioning a seed conductor (22) on the substrate (12);
applying a layer of resist patterned with a negative image of a desired circuit trace (14);
placing a first layer of noble metal (16) in the negative image of the desired circuit trace (14);
plating a layer of conductive material (28) over the first layer of noble metal (16) to form the desired circuit trace (14);
removing the layer of resist from the substrate (12);
removing the seed conductor (22) from the substrate (12) other than from the (12) in the desired circuit trace (14); and
plating a second layer of the noble metal (16) over the layer of conductive material (28).

9. A method of forming a printed circuit board, comprising the steps of:
providing a dielectric substrate (12);
positioning a seed conductor (22) on the substrate (12);
forming a first layer of a noble metal (16) on the substrate (12);
plating a layer of a conductive material (28) over the layer of noble metal (16);
applying a layer of resist patterned with an image of a desired circuit trace (14);
removing the layer of conductive material (28), noble metal (16) and the seed conductor (22) from the substrate (12) to leave the desired circuit trace (14) then removing the resist; and
plating a second layer of the noble metal (16) over the layer of conductive material (28).

10. The method of claim 8 or 9, wherein the noble metal (16) comprises silver.

11. The method of claim 10, wherein the conductive material (28) is copper.

12. The method of claim 11, wherein the layer of the noble metal (16) is about 0.305 µm (12 microinches) thickness.

13. The method of claim 12, wherein the dielectric material is polytetrafluoroethylene.

14. The method of claim 13, wherein the printed circuit board has a maximum operating temperature of at least 200 degrees Celsius.
